# EUROPÄISCHE PATENTSCHRIFT

(11) **EP 4 173 020 B1**
(45) Veröffentlichungstag und Bekanntmachung des Hinweises auf die Patenterteilung: **10.04.2024**
(21) Anmeldenummer: 21737009.7
(22) Anmeldetag: 23.06.2021
(51) Int. Cl.: H01J 37/32, H05H 1/24

(54) **PLASMAREAKTOR ZUR PLASMACHEMISCHEN UND/ODER PLASMAKATALYTISCHEN UMSETZUNG VON VERBINDUNGEN SOWIE VERWENDUNG EINES PLASMAREAKTORS**
PLASMA REACTOR FOR THE PLASMA-CHEMICAL AND/OR PLASMA-CATALYTIC CONVERSION OF COMPOUNDS, AND USE OF A PLASMA REACTOR
RÉACTEUR À PLASMA PERMETTANT LA CONVERSION PLASMA-CATALYTIQUE ET/OU PLASMA-CHIMIQUE, ET UTILISATION D'UN RÉACTEUR À PLASMA

(30) Priorität: 24.06.2020 DE 102020116630
(43) Veröffentlichungstag der Anmeldung: 03.05.2023
(73) Patentinhaber: Fraunhofer-Gesellschaft zur Förderung der angewandten Forschung e.V., 80686 München (DE)
(72) Erfinder: NITSCHE, Tim, 46047 Oberhausen (DE); HAPKE, Vanessa, 45136 Essen (DE); ALTHAUS, Wilhelm, 59439 Holzwickede (DE); SEIFERT, Ulrich, 45239 Essen (DE)
(74) Vertreter: Cohausz & Florack
(86) Internationale Anmeldenummer: PCT/EP2021/067181
(87) Internationale Veröffentlichungsnummer: WO 2021/260023

(56) Entgegenhaltungen:
- CN-A- 108 392 951
- DE-A1-102016 108 450
- DE-C1- 19 518 970
- JP-A- 2001 276 561
- JP-A- 2008 130 343
- KR-A- 20190 080 597

## Beschreibung

Die Erfindung betrifft einen Plasmareaktor zur plasmachemischen und/oder plasmakatalytischen Umsetzung von Verbindungen in einem Reaktorfluid mittels dielektrischer Barriereentladung, umfassend zwei wenigstens über ein Dielektrikum und wenigstens abschnittsweise über wenigstens einen Reaktionskanal zum Durchströmen des Reaktorfluids voneinander getrennte Elektroden, wobei der Reaktionskanal zum Durchströmen mit dem Reaktorfluid wenigstens im Wesentlichen parallel zu einer Reaktorlängserstreckung ausgebildet ist. Des Weiteren betrifft die Erfindung eine Verwendung eines solchen Plasmareaktors.

Plasmareaktoren sind bereits in unterschiedlichen Ausgestaltungen bekannt. Sie weisen wenigstens einen Reaktionskanal auf, in dem ein Plasma erzeugt bzw. bereitgestellt wird, das genutzt wird, um in wenigstens einem Reaktionskanal eine chemische Umsetzung bestimmter Verbindungen zu bewirken, die im sogenannten Reaktorfluid enthalten sind. Dabei können die Verbindungen bedarfsweise nur einen geringen Teil des Reaktorfluids bilden, das im Wesentlichen durch ein Trägerfluid oder eine Trägerfluidmischung gebildet sein kann. Dabei kann das Plasma genutzt werden, um die gewünschte Umsetzung bzw. Reaktion überhaupt in Gang zu setzen, um die Reaktion bei gleicher Prozesstemperatur zu beschleunigen, um die Selektivität der Umsetzung zu erhöhen, um den Umsatz zu steigern und/oder um die Ausbeute an Reaktionsprodukt zu erhöhen. Plasmareaktoren werden zudem sowohl für die Synthese bestimmter Verbindungen als auch zur Entfernung bestimmter Verbindungen aus dem Reaktorfluid benutzt. Zudem erfolgt die Umsetzung der Verbindungen in der fluiden Phase insbesondere in der Gasphase, der Flüssigphase in Mischungen aus Gas- und/oder Flüssigphasen sowie in überkritischen Fluiden. Plasmareaktoren können aber auch mit dispersen Mischphasen betrieben werden.

Beispielsweise werden Plasmareaktoren zur Abgas-, Abluft- oder Abwasserreinigung eingesetzt.

Plasmachemische Reaktionen sind solche Reaktionen, welche durch reaktive Spezies aus einem Plasma (Ionen, Elektronen, Radikale; elektrisch, vibrationsmäßig oder rotationsmäßig angeregte Atome/Moleküle) initiiert werden. Plasmakatalytische Reaktionen sind plasmachemische Umsetzungen mit zusätzlicher Unterstützung einer katalytisch aktiven Spezies, die an den Berandungen oder dispers in den Strömungsraum des Reaktorfluids oder mit dem Reaktorfluid selbst in den Strömungsraum eingebracht wird.

Unter Plasmareaktoren werden vorliegend insbesondere solche verstanden, bei denen ein atmosphärisches Niedertemperaturplasma mittels dielektrischer Barriereentladung und Wechselspannung erzeugt wird. Man spricht in diesem Zusammenhang auch von einer stillen elektrischen Entladung, dielektrischen Barriereentladung (DBE) oder Dielectric Barrier Discharge (DBD), bei der die Elektroden von wenigstens einem Reaktionskanal durch eine galvanische Trennung mittels eines Dielektrikums getrennt werden, um den wenigstens einen Reaktionskanal zu isolieren. Um eine Entladung zu erzeugen, muss eine hinreichende elektrische Feldstärke im wenigstens einen Reaktionskanal erzeugt werden. Meist werden hierzu Spannungen von einigen Kilovolt und Frequenzen im Kilohertz-Bereich verwendet. Grundsätzlich kann aber auch ein erweiterter Frequenzbereich im Hz- bis MHz-Bereich verwendet werden. Zur Umsetzung in der flüssigen Phase oder in überkritischen Fluiden bietet sich neben dem atmosphärischen Niederdruckplasma auch die Erzeugung eines Plasmas unter deutlichem Überdruck an.

Um überhaupt zuverlässig und ohne übermäßigen Aufwand ein Plasma erzeugen zu können und/oder ein möglichst homogenes Plasma bereitstellen zu können, darf der Reaktionskanal, insbesondere der freie Strömungsquerschnitt des Reaktionskanals, nicht zu groß gewählt werden. Für eine gute Homogenität sollte der Querschnitt auf alle Reaktionskanäle möglich gleichmäßig verteilt sein. Eine Behandlung höherer Volumenströme erfordert mithin die Bereitstellung einer Vielzahl von Reaktionskanälen. Für ein entsprechendes Hochskalieren über die Erhöhung der Anzahl der Reaktionskanäle, was auch als Numbering-Up bezeichnet wird, wurden bereits unterschiedliche Methoden vorgeschlagen. Beispielsweise wird eine Anordnung vieler Reaktionskanäle in Form eines Rohrbündelreaktors vorgeschlagen, was jedoch zu einer sehr aufwendigen Verkabelung der verschiedenen Reaktorräume sowie zu einem erheblichen Raumbedarf zur Aufnahme der vielen Reaktionskanäle führt. Alternativ werden sogenannte Stackanordnungen vorgeschlagen, bei denen einzelne Platten ähnlich einem Brennstoffzellenstack übereinandergestapelt werden. In den so entstehenden Schichten werden dann mehrere Lagen Reaktionskanäle übereinander bereitgestellt. Daneben existieren noch Sonderformen von Anordnungen vieler Reaktionskanäle, die grundsätzlich sehr aufwändig in der Herstellung sind und beispielsweise eine sehr große Anzahl an separaten Elektroden erfordern. Im Ergebnis stehen bislang noch keine Reaktoren zur Verfügung, die mit geringem Aufwand auch zur Behandlung von technisch großen Volumenströmen problemlos hochskaliert werden können. Reaktoren zur plasmachemischen und/oder plasmakatalytischen Umsetzung von Verbindungen in einem Reaktorfluid mittels dielektrischer Barriereentladung sind aus CN108392951B, JP2008130343A, KR20190080597A, DE19518970C1, und JP2001276561A bekannt.

Daher liegt der vorliegenden Erfindung die Aufgabe zugrunde, den eingangs genannten und zuvor näher beschriebenen Plasmareaktor derart auszugestalten und weiterzubilden, dass dieser einfach, schnell und kostengünstig hochskaliert werden kann, um auch größere Volumenströme an Reaktorfluiden im Plasmareaktor behandeln zu können.

Diese Aufgabe ist bei einem Plasmareaktor nach dem Oberbegriff des Anspruchs 1 dadurch gelöst, dass die Elektroden und das Dielektrikum spiralförmig um die Reaktorlängserstreckung gewickelt sind.

Der Plasmareaktor kann also einen spiralförmig aufgewickelten Schichtverbund aufweisen, der, insbesondere vor dem Aufwickeln, wenigstens zwei aus Elektroden gebildete Schichten und wenigstens eine aus einem Dielektrikum gebildete, zwischen den Elektroden vorgesehene Schicht umfasst. Es können jedoch weitere Schichten vorgesehen sein. Insbesondere kann der Schichtverbund eine weitere Schicht aus einem Dielektrikum oder einem elektrisch isolierenden Material aufweisen. Diese Schicht kann so auf einer Außenseite einer Elektrode vorgesehen sein, dass bei einem spiralförmigen Aufwickeln des Schichtverbunds die beiden Elektroden einerseits durch das Dielektrikum und andererseits durch die weitere Schicht voneinander getrennt sind. Des Weiteren kann der Schichtverbund grundsätzlich noch weitere Schichten in Form von Elektroden, Dielektrika und/oder elektrisch isolierenden Materialien aufweisen, auch wenn dies nicht erforderlich ist. Es können auch in wenigstens einem Zwischenraum zwischen zwei Elektroden zwei oder mehr Dielektrika vorgesehenen sein, und zwar insbesondere in Reihe zwischen den Elektroden.

Der Schichtverbund lässt sich zur Bildung des Plasmareaktors spiralförmig um die Reaktorlängserstreckung aufwickeln. Durch das spiralförmige Aufwickeln des Schichtverbunds steigt der Wickelradius des Schichtverbunds mit der Anzahl der Wicklungen des Schichtverbunds um die Reaktorlängsachse an. Es ergibt sich also insbesondere eine Wicklung nach Art eines Schneckenhauses oder der Rille einer Schallplatte. Mithin ist die spiralförmige Wicklung des Schichtverbunds grundsätzlich von einer schraubenförmigen Wicklung des Schichtverbunds zu unterscheiden, die beispielsweise nach Art einer Wendel oder Helix ausgebildet sein kann. Bei schraubenförmigen Wicklungen ist der Radius der einzelnen Windungen nämlich anders als bei einer Spirale wenigstens im Wesentlichen konstant.

Eine Skalierung des Plasmareaktors kann sehr einfach, kostengünstig und gezielt dadurch erfolgen, dass die Elektroden zusammen mit dem wenigstens einen dazwischen vorgesehenen, wenigstens einen Reaktionskanal aufweisenden Dielektrikum spiralförmig aufgewickelt werden. Mithin können in vorteilhafter Weise für unterschiedliche Anwendungsfälle bei verschiedenen Plasmareaktoren unterschiedliche Reaktionsvolumen auch hinsichtlich der bereitgestellten medienberührten Werkstoffe und Oberflächen sehr exakt eingestellt werden. Die Anzahl der Wicklungen kann sich nach dem jeweiligen Volumenstrom des zu behandelnden Reaktorfluids, den Strömungsbedingungen und der erforderlichen Verweilzeit richten. Hinsichtlich der Verweilzeit kann zudem der Vorteil genutzt werden, dass das Aufwickeln des Schichtverbunds aus den Elektroden und dem wenigstens einen dazwischen angeordneten Dielektrikum prinzipiell unabhängig von der Reaktorlängserstreckung ist. Mit anderen Worten kann die Länge des Reaktors bedarfsweise unabhängig von der Anzahl der Wicklungen oder der Anzahl der Reaktionskanäle gewählt werden. Dabei sind jedoch bedarfsweise der entsprechende Druckverlust und die entsprechende Verweilzeit zu berücksichtigen.

Im Übrigen kann durch das Aufwickeln eine sehr exakte Anpassung des jeweiligen Plasmareaktors an die jeweiligen Anforderungen erreicht werden. Bei Plasmareaktoren in Form von Stacks wird das Volumen der Reaktionskanäle immer ein ganzzahliges Vielfaches des Volumens des Reaktionsvolumens einer Platte sein. Auch bei Plasmareaktoren in Form von Rohrbündelapparaten sind fertigungstechnisch bestimmte Vorgaben einzuhalten, die eine sehr individuelle Anpassung der Plasmareaktoren erschweren. Durch den Aufbau als Stack bzw. Rohrbündelapparat treten zudem zahlreiche zusätzliche Dicht- und Bearbeitungsflächen auf. Beim erfindungsgemäßen Aufwickeln des Schichtverbunds aus den Elektroden und dem wenigstens einen dazwischen angeordneten Dielektrikum treten dagegen nahezu keine Änderungen einer ganzen Reihe von für den Plasmareaktor, insbesondere für die Reaktionskanäle relevanten Abständen und Abmessungen auf, und zwar unabhängig davon, wie viele Wicklungen des Schichtverbunds aus den Elektroden und dem wenigstens einen dazwischen angeordneten Dielektrikum vorgesehen werden. Zudem wird die Anzahl der Dicht-und Bearbeitungsflächen minimiert.

Beim Aufwickeln der Elektroden und des wenigstens einen Dielektrikums ist dafür Sorge zu tragen, dass ein Kurzschluss durch eine unmittelbare Berührung der beiden Elektroden vermieden wird. Es kann also neben einem den wenigstens einen Reaktionskanal bereitstellenden Dielektrikum zwischen den Elektroden noch ein weiteres Dielektrikum vorgesehen werden, das an einer Elektrode, beispielsweise auf der dem anderen Dielektrikum abgewandten Seite der Elektrode, angeordnet sein kann. Beim Aufwickeln der entsprechenden Lagen oder Schichten sind die Elektroden dann jeweils über mindestens ein Dielektrikum voneinander getrennt. Besonders einfach und effizient ist es in diesem Zusammenhang, wenn die beiden Dielektrika gleichartig ausgebildet sind und wenn beide Dielektrika jeweils Reaktionskanäle aufweisen. Alternativ können die Elektroden im Plasmareaktor aber auch einerseits durch das Dielektrikum und andererseits durch eine isolierende Schicht voneinander getrennt sein, wobei diese Schicht eine ausreichende elektrische Isolation der beiden Elektroden gegeneinander bewirkt. Diese Isolation kann bedarfsweise Temperierkanäle zum Hindurchleiten von Wärmeträgerfluid aufweisen, um den Plasmareaktor zu temperieren, also zu erhitzen oder zu kühlen.

Bei einer ersten besonders bevorzugten Ausgestaltung des Plasmareaktors sind die Elektroden und das wenigstens eine Dielektrikum wenigstens zweimal, vorzugsweise wenigstens dreimal, insbesondere wenigstens fünfmal, spiralförmig um die Reaktorlängserstreckung gewickelt. In diesem Fall kann auf kleinem Raum ein großes und gleichmäßig partitioniertes Reaktionsvolumen mit lokal sehr ähnlichen Reaktionsbedingungen bereitgestellt werden. Dies gilt grundsätzlich umso mehr, je mehr Wicklungen vorgesehen sind. Um die Fertigung der Plasmareaktoren zu vereinfachen und die Langlebigkeit der Plasmareaktoren zu steigern, kann es sich alternativ oder zusätzlich anbieten, die Elektroden und das wenigstens eine Dielektrikum um einen Spulenkern herum zu wickeln.

Der wenigstens eine Reaktionskanal kann durch eine der beiden Elektroden und/oder durch das wenigstens eine Dielektrikum begrenzt sein. Wenn der wenigstens eine Reaktionskanal wenigstens teilweise durch eine Elektrode begrenzt wird, können hier entsprechende Oberflächeneffekte oder katalytische Wirkungen der Elektrode für die Umsetzung der Verbindungen genutzt werden. Jeder Reaktionskanal ist aber von wenigstens einer der beiden Elektroden durch das zugehörige Dielektrikum getrennt. Wenn der wenigstens eine Reaktionskanal vollständig im Dielektrikum vorgesehen ist, d. h. räumlich getrennt von beiden Elektroden, können die Reaktionskanäle sehr einfach und zuverlässig vorgesehen werden, indem das wenigstens eine Dielektrikum zwischen die Elektroden gebracht wird.

Bedarfsweise kann es zweckmäßig sein, wenn wenigstens ein Reaktionskanal durch eine der beiden Elektroden und wenigstens ein anderer Reaktionskanal durch die andere Elektrode begrenzt wird. Dies ist besonders einfach zu realisieren, wenn benachbarte Reaktionskanäle jeweils teilweise durch unterschiedliche Elektroden begrenzt werden. Anders ausgedrückt begrenzen die Elektroden jeweils immer den übernächsten Reaktionskanal.

Dies kann zur Optimierung des nutzbaren Strömungsquerschnittes im wenigstens einen Dielektrikum beitragen. Weiterhin kann damit eine gleichmäßige Belastung der Elektroden mit den Plasmaspezies bzw. eine Reaktion mit der Elektrodenoberfläche erreicht werden. Weiterhin könnte man dadurch auch zwei separate Reaktionsfluide durch einen Plasmareaktor leiten, etwa kombiniert mit einer Trennmembrananlage.

Um zuverlässig ein homogenes Plasma erzeugen und zudem eine gute Skalierbarkeit des Reaktorvolumens zu ermöglichen, bietet es sich an, wenn eine Mehrzahl, vorzugsweise eine Vielzahl, insbesondere wenigstens 20, weiter insbesondere wenigstens 50, separater parallel verlaufender Reaktionskanäle vorzusehen. Dabei ist die Anordnung dieser Reaktionskanäle besonders einfach möglich, wenn die Reaktionskanäle wenigstens im Wesentlichen parallel zueinander und/oder wenigstens im Wesentlichen parallel zur Reaktorlängserstreckung vorgesehen sind. Der einzelne Reaktionskanal kann dabei aber auch periodisch wechselnde Querschnitte aufweisen und periodisch wechselnde Strömungsrichtungen bereitstellen. Beispielsweise sind schraubenförmige oder mäandernde Reaktionskanäle denkbar.

Alternativ oder zusätzlich kann, um zuverlässig ein homogenes Plasma zu erzeugen und zudem eine gute Skalierbarkeit des Reaktorvolumens zu erreichen, auch die freie Querschnittsfläche des wenigstens einen Reaktionskanals in geeigneter Weise ausgebildet werden. Die Reaktionskanäle sollten dabei nicht zu klein sein, um einen hohen Durchsatz bei einem geringen Druckverlust sicherstellen zu können. Die Reaktionskanäle sollten aber auch nicht zu groß werden, was sich negativ auf die Feldstärke und eine insbesondere gleichmäßige Plasmaerzeugung auswirken kann. Besonders zweckmäßig ist es daher, wenn der wenigstens eine Reaktionskanal eine freie Querschnittsfläche von wenigstens 0,5 mm², vorzugsweise wenigstens 1 mm², insbesondere wenigstens 5 mm² aufweist und/oder dass der wenigstens eine Reaktionskanal eine freie Querschnittsfläche von weniger als 200 mm², vorzugsweise von weniger als 100 mm², insbesondere von weniger als 50 mm² aufweist.

Der zuverlässigen Ausbildung eines homogenen Plasmas bei gleichzeitig guter Skalierbarkeit ist es alternativ oder zusätzlich auch dienlich, wenn der freie Querschnitt des wenigstens einen Reaktionskanals rund, oval, halbkreisförmig, rechteckig, dreieckig, trapezförmig, quadratisch oder polygonal ist. Auch mathematisch komplexere Flächenelemente können für die Umsetzung zweckmäßig sein. Die Gestaltung des Querschnitts des wenigstens einen Reaktionskanals hat unmittelbaren Einfluss auf das Feldlinienbild bzw. auf die Verteilung der Feldliniendichte. Je ungleichmäßiger die Feldliniendichte ist, desto eher besteht die Möglichkeit, dass sich unterschiedlich intensive Plasmazonen über die Raumkoordinaten verteilen. Dies kann für eine sichere Plasmabildung förderlich sein. Die Verteilung im Reaktionsfluid wird durch geometrieabhängige Sekundärströmungen verbessert.

Um ein wirksames und zugleich beständiges Dielektrikum bereitzustellen, kann dieses bevorzugt aus einem Kunststoff gebildet sein, wobei sich Elastomere, wie Silikone oder Kautschuke (z. B. Acrymitril-Budadien-Kautschuk (NBR)) sowie thermoplastische Elastomere (z. B. Copolymere etc.), insbesondere Polydimethylsiloxan (PDMS) eignen. Thermoplaste (Polyethylen (PE), Polypropylen (PP), Polytetrafluoroethylen (PTFE), Polyetheretherketone (PEEK) etc.) kommen mit für die Wicklung geeigneten, geringen Wandstärken in Frage, und zwar bedarfsweise mit weiteren Isolationsschichten zur Verbesserung der Durchschlagfestigkeit.

Keramische Folien wären ebenfalls eine Option als Dielektrikum, insbesondere bei höheren Prozesstemperaturen. Zudem kann wenigstens eine der Elektroden aus Edelstahl, Kupfer, Kupferlegierungen, Nickel, Silber oder anderen Edelmetallen (z. B. Platin oder Palladium), eventuell auch aus Graphit oder Graphit-Compounds bestehen.

Um eine plasmakatalytische Umsetzung im Plasmareaktor zu erreichen, kann es sich der Einfachheit halber anbieten, wenn der wenigstens eine Reaktionskanal wenigstens abschnittsweise eine Katalysatorbeschichtung aufweist. Dabei ist in der Regel besonders effektiv, wenn das wenigstens eine Dielektrikum und/oder wenigstens eine Elektrode katalysatorbeschichtet ist. Als Katalysatoren kommen insbesondere Übergangsmetalle (z. B. Kupfer, Platin oder Nickel), oberflächenfixierte (Organo-)Metallkomplexe, Metalloxide (z. B. Aluminiumoxid (Al₂O₃), Vanadiumoxid (V₂O₅), Titandioxid (TiO₂) oder Cerdioxid (CeO₂) als auch Biokatalysatoren in Frage.

Um die Reaktionstemperatur für die Umsetzung im Plasmareaktor gezielt einstellen zu können, bietet es sich an, wenn zwischen den Elektroden wenigstens einen Temperierkanal zum Hindurchleiten eines Wärmeträgerfluids zum Beheizen oder Kühlen des wenigstens einen Reaktionskanals vorzusehen. Dabei wird es insbesondere zweckmäßig sein, wenn mehrere Temperierkanäle zum Durchleiten von Wärmeträgerfluid vorgesehen sind. Bedarfsweise kann in mehr oder weniger regelmäßigen Abständen zugunsten eines Temperierkanals auf einen Reaktionskanal verzichtet werden. Dann können auch die Temperierkanäle vorzugsweise wenigstens im Wesentlichen parallel zueinander und/oder wenigstens im Wesentlichen parallel zu dem wenigstens einen Reaktionskanal angeordnet sein. Der wenigstens eine Temperierkanal kann beispielsweise in wenigstens einem Dielektrikum und/oder wenigstens einer Isolationsschicht vorgesehen sein.

Temperierkanäle und Trennmembranen können neben der alternierenden Anordnung zu Reaktionskanälen auch als zusätzliche Zwischenlage im Plasmareaktor und plasmakatalytischen Reaktor angeordnet sein.

Die zuvor genannten Vorteile lassen sich insbesondere dann nutzen, wenn der Plasmareaktor nach einem der Ansprüche 1 bis 10 zur Reduzierung von Restsauerstoff aus Synthesegas oder Hüttengas und/oder zum Entfernen von Stickoxiden, Schwefeloxiden, Lachgas, flüchtigen organischen Verbindungen (VOC), Methan, Propan, Ammoniak, Geruchsstoffen und/oder Partikeln aus Synthesegas, Prozessgas oder Abgas eingesetzt wird. Alternativ oder zusätzlich kann der Plasmareaktor zur Entfernung von Odorierungsmittel aus Erdgas sowie zur Entfernung von Ruß oder Gerüchen aus Gasen sowie zur Abtötung von Mikroorganismen wie Keimen, Bakterien, Sporen, Pilzen in Fluiden genutzt werden. Bei all diesen Anwendungszwecken, lässt sich eine plasmagestützte Umsetzung gewinnbringend nutzen und es ist dazu regelmäßig eine gezielte Anpassung des Reaktionsvolumens an den jeweiligen Anwendungsfall erforderlich, da die entsprechenden Fluide, insbesondere Gase, in sehr unterschiedlichen Volumenströmen anfallen bzw. verarbeitet werden müssen.

Bei den zuvor genannten Verwendungen des Plasmareaktors aber auch bei weiteren Verwendungen ist es grundsätzlich zweckmäßig, ein atmosphärisches Plasma und/oder ein Niedertemperaturplasma zu erzeugen. Diese lassen sich zweckmäßig erzeugen und besonders effizient bei temperaturempfindlichen Reaktorfluiden oder Oberflächen (z. B. funktionalisierte Kunststoffflächen oder biologische Oberflächen) für plasmachemische und/oder plasmakatalytische Umsetzungen einsetzen. Je nach Prozessführung kann dieses Plasma bei Reaktorwerkstoffen mit moderater Temperaturbeständigkeit eingesetzt werden. Die Konstruktion des Plasmareaktors und plasmakatalytischen Reaktors kann einen Einsatz für gasförmige, flüssige, überkritische und mehrphasige Fluide erlauben, und zwar bedarfsweise auch dann, wenn diese unter höherem Druck stehen, da der Druck problemlos auf eine druckfeste äußere Umhüllung abgeleitet werden kann.

Nachfolgend wird die Erfindung anhand einer lediglich Ausführungsbeispiele darstellenden Zeichnung näher erläutert. In der Zeichnung zeigt
- Fig. 1: die Verwendung eines erfindungsgemäßen Plasmareaktors in einer schematischen Seitenansicht,
- Fig. 2: den Aufbau des erfindungsgemäßen Plasmareaktors aus Fig. 1 in einer schematischen, perspektivischen Darstellung,
- Fig. 3: den erfindungsgemäßen Plasmareaktor aus Fig. 1 in einer schematischen Querschnittsansicht,
- Fig. 4A-C: die Anordnung von Reaktionskanälen eines Plasmareaktors zwischen den die Reaktionskanäle abwechselnd begrenzenden Elektroden in einer schematischen Schnittansicht,
- Fig. 5A-D: die Anordnung von durch eine Elektrode begrenzten Reaktionskanälen eines Plasmareaktors in einer schematischen Schnittansicht und
- Fig. 6A-C: die Anordnung von ausschließlich durch das Dielektrikum begrenzten Reaktionskanälen eines Plasmareaktors zwischen den Elektroden in einer schematischen Schnittansicht.

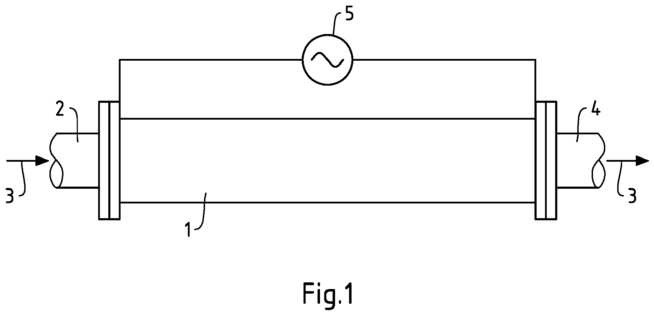

In der Fig. 1 ist ein Plasmareaktor 1 in einer Seitenansicht dargestellt. Dem Plasmareaktor 1 wird über eine Leitung 2 ein Reaktorfluid 3, insbesondere ein Gas, weiter insbesondere eine Mischung aus mehreren Gasen, zugeführt, das wenigstens eine Verbindung enthält, welche in dem Plasmareaktor 1 plasmachemisch und/oder plasmakatalytisch umgesetzt wird. Es kann als Reaktorfluid 3 aber auch eine Flüssigkeit oder eine Mischung aus verschiedenen Fluiden verwendet werden. Zudem ist es nicht ausgeschlossen, dass das Reaktorfluid 3 auch Feststoffpartikel enthält.

Dabei kann die Umsetzung der Verbindung mit dem Ziel erfolgen, den Gehalt der entsprechenden Verbindung in dem Reaktorfluid 3 zu verringern oder um durch die Umsetzung ein bestimmtes Produkt zu synthetisieren. Das Reaktorfluid 3 wird nach der Umsetzung über eine weitere Leitung 4 aus dem Plasmareaktor 1 abgeführt. Der dargestellte und insoweit bevorzugte Plasmareaktor 1 ist dabei an die beiden Leitungen 2,4 angeflanscht. Das Reaktorfluid 3 strömt dabei an einem Längsende des Plasmareaktors 1 ein und an dem gegenüberliegenden Längsende des Plasmareaktors 1 nach erfolgter Umsetzung einer entsprechenden Verbindung und somit mit geänderter Zusammensetzung wieder aus. Mithin entspricht die Strömungsrichtung des Reaktorfluids 3 wenigstens im Wesentlichen der Längserstreckung des Plasmareaktors 1. Der Plasmareaktor 1 ist an eine Spannungsquelle 5 angeschlossen, die die Elektroden des Plasmareaktors 1 insbesondere mit Wechselspannung versorgt, wobei die Spannung und die Frequenz hoch genug sind, um in dem Plasmareaktor 1 ein Plasma zu erzeugen.

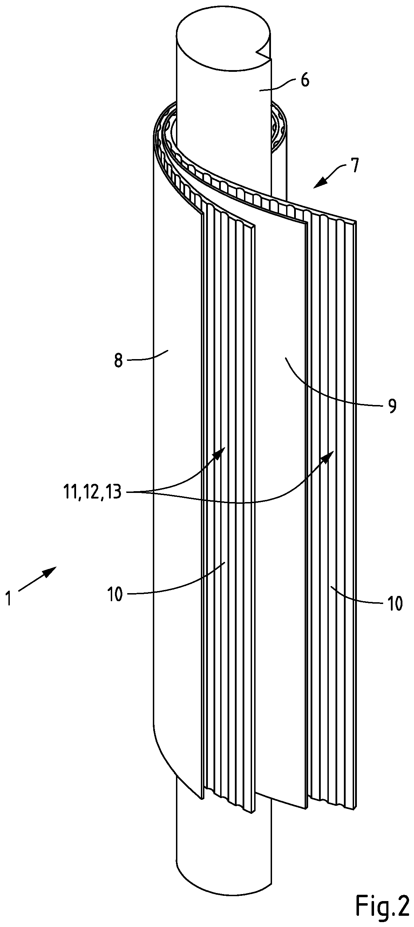

In der Fig. 2 ist der Aufbau des Plasmareaktors 1 aus der Fig. 1 näher dargestellt. Im Zentrum des Plasmareaktors 1 erstreckt sich in der Reaktorlängserstreckung ein Spulenkern 6, um den herum spiralförmig ein Schichtverbund 7 umfassend zwei Elektroden 8,9, ein dazwischen angeordnetes Dielektrikum 10 sowie ein weiteres an der Außenseite einer Elektrode 9 angeordnetes Dielektrikum 10 aufgewickelt ist. Dabei füllt wenigstens ein Dielektrikum 10 den Zwischenraum zwischen den Elektroden 8,9 nicht vollständig aus, sondern lässt eine Vielzahl voneinander beabstandete und parallel zueinander verlaufende Strömungskanäle 11 frei, die stirnseitig an den beiden Längsenden des Plasmareaktors 1 offen sind. Diese Strömungskanäle 11 werden dabei insbesondere als Reaktionskanäle 12 zum Durchströmen mit Reaktorfluid 3 in der Reaktorlängserstreckung genutzt. Dabei können einzelne der Strömungskanäle 11 auch als Temperierkanäle 13 zum Durchleiten eines Wärmeträgerfluids zum Beheizen oder Kühlen der angrenzenden Reaktionskanäle 12 vorgesehen sein. Bedarfsweise könnten die Strömungskanäle 11 in einem Dielektrikum 10 als Reaktionskanäle 12 und die Strömungskanäle 11 in dem anderen Dielektrikum 10 als Temperierkanäle 13 genutzt werden. Alternativ können aber auch in jedem Dielektrikum 10 jeweils ein Teil der Strömungskanäle 11 als Reaktionskanäle 12 und ein Teil der Strömungskanäle 11 als Temperierkanäle 13 genutzt werden, beispielsweise jeweils abwechselnd. Über die Dielektrika 10 werden die beiden Elektroden 8,9 zudem in einem vorbestimmten Abstand zueinander gehalten. Um die beiden Elektroden 8,9 zuverlässig voneinander zu isolieren, stehen die Dielektrika 10 an den beiden Längsenden des Plasmareaktors 1 gegenüber den beiden Elektroden 8,9 nach außen vor, was zugunsten der besseren Anschaulichkeit in der Fig. 2 nicht dargestellt worden ist. In der Fig. 2 ist der besseren Anschaulichkeit halber auch nicht dargestellt, dass die spiralförmige Wicklung der beiden Elektroden 8,9 und der Dielektrika 10 von einem Gehäuse umschlossen ist.

Grundsätzlich könnte ein Dielektrikum 10 der beiden Dielektrika 10 ohne Strömungskanäle 11 verwendet werden. Es stehen dann dort keine Strömungskanäle 11 zum Durchleiten eines Reaktorfluids 3 und/oder eines Wärmeträgerfluids zur Verfügung. Der Plasmareaktor 1 könnte aber dennoch zur Durchführung der gewünschten Reaktion in dem Dielektrikum 10 mit Strömungskanälen 11 genutzt werden, auch wenn dies gegebenenfalls zur einer verringerten Effizienz oder Leistungsdichte führt. Das zweite Dielektrikum 10 würde dann primär der Isolation der beiden Elektroden 8,9 dienen. Wenn gleiche Dielektrika 10 verwendet werden, ist dies besonders einfach hinsichtlich der Fertigung der Plasmareaktoren 1 und der Lagerhaltung für die Fertigung der Plasmareaktoren 1. Des Weiteren könnte auch grundsätzlich auf ein zweites Dielektrikum 10 verzichtet werden, wenn die beiden Elektroden 8,9 durch eine geeignete elektrische Isolation hinreichend elektrisch voneinander isoliert sind. Die Isolation kann bedarfsweise Temperierkanäle 13 zum Hindurchleiten von Wärmeträgerfluid aufweisen, um den Plasmareaktor 1 zu temperieren, also zu erhitzen oder zu kühlen.

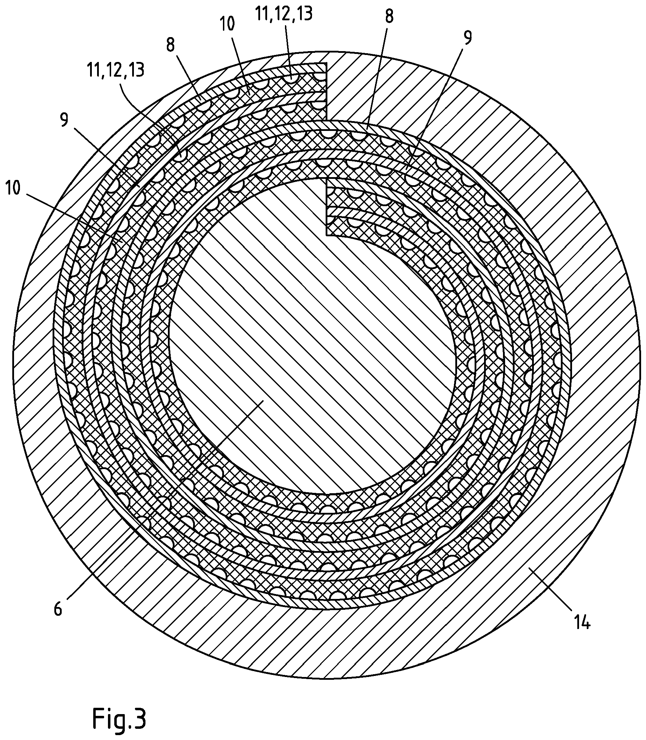

In der Fig. 3 ist der Plasmareaktor 1 in einem Querschnitt dargestellt. Um den inneren Spulenkern 6 sind die beiden Elektroden 8,9 und die beiden Dielektrika 10 herumgewickelt, die mithin im Querschnitt spiralförmig um den Spulenkern 6 herum umlaufen. In die Dielektrika 10 sind die Reaktionskanäle 12 eingebracht, die mithin nicht nur die beiden Elektroden 8,9 in dem vorbestimmten Abstand zueinander halten, sondern auch die Strömungskanäle 11 definieren. Die Wicklung aus dem Schichtverbund 7 umfassend die beiden Elektroden 8,9 und die Dielektrika 10 wird nach außen durch ein Gehäuse 14 umschlossen. Die Innenkontur des Gehäuses 14 ist ebenso wie die Außenkontur des Spulenkerns 6 ist bei dem dargestellten und insoweit bevorzugten Plasmareaktor 1 nicht völlig kreisförmig oder rotationssymmetrisch ausgebildet, um der gemeinsamen Wicklung der Elektroden 8,9 und der Dielektrika 10 Rechnung zu tragen.

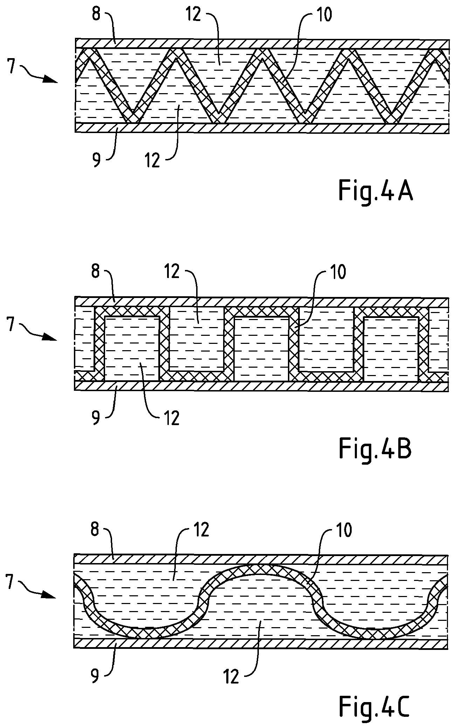

In den Fig. 4A-C sind beispielhaft verschiedene Schichtverbunde 7 umfassend die beiden Elektroden 8,9 und ein dazwischen angeordnetes Dielektrikum 10 dargestellt, wobei die nebeneinander angeordneten Reaktionskanäle 12 abwechselnd an die gegenüberliegenden Elektroden 8,9 angrenzen und ansonsten durch das Dielektrikum 10 begrenzt sind. Im Ausführungsbeispiel gemäß Fig. 4A ist das Dielektrikum 10 dabei sägezahnförmig angeordnet und sind somit dreieckige Reaktionskanäle 12 gebildet, während das Dielektrikum 10 gemäß Fig. 4B stufenförmig verläuft und dabei rechteckige Reaktionskanäle 12 bildet. In der Fig. 4C ist ein wellenförmig oder sinusförmig verlaufendes Dielektrikum 10 dargestellt, das dementsprechend annähernd halbkreisförmige Reaktionskanäle 12 bildet.

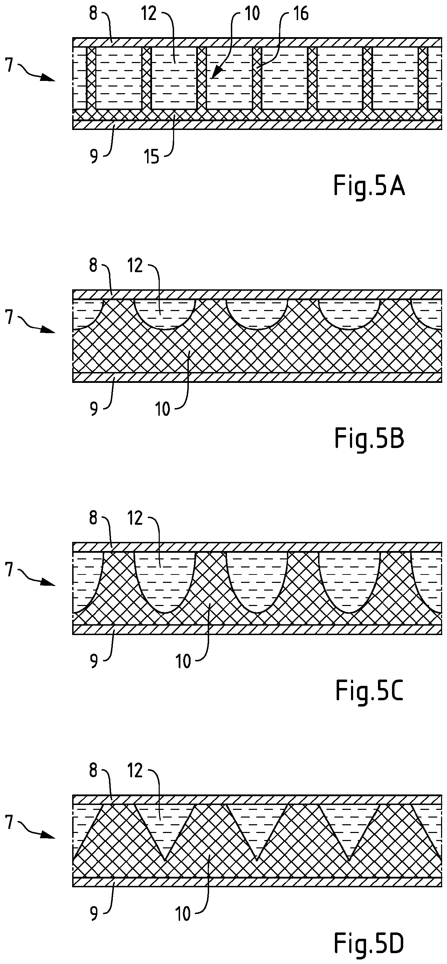

In den Fig. 5A-D sind beispielhaft verschiedene Schichtverbunde 7 umfassend die beiden Elektroden 8,9 und ein dazwischen angeordnetes Dielektrikum 10 dargestellt, wobei die nebeneinander angeordneten Reaktionskanäle 12 stets an ein und dieselbe Elektrode 8 der beiden Elektroden 8,9 angrenzen und ansonsten durch das Dielektrikum 10 begrenzt sind. Im Ausführungsbeispiel gemäß Fig. 5A weist das Dielektrikum 10 eine flächig an einer der beiden Elektroden 9 anliegende Schicht 15 auf, von der aus sich eine Reihe von rechteckigen Stegen 16 bis hinüber zur gegenüberliegenden Elektrode 8 erstrecken. Mit dem entsprechend ausgebildeten Dielektrikum 10 werden rechteckige Reaktionskanäle 12 gebildet. In den Fig. 5B und 5C sind dagegen Dielektrika 10 dargestellt, bei denen sich die Stege 16 des Dielektrikums 10 in Richtung der gegenüberliegenden Elektrode 8 wenigstens grundsätzlich verjüngen. Durch diese Dielektrika 10 werden die Reaktionskanäle 12 wenigstens im Wesentlichen mit einem halbkreisförmig oder ähnlich eines halben Ovals ausgebildeten Querschnitt bereitgestellt. Wenn die Stege 16 des Dielektrikums 10 sich, wie dies bei dem in der Fig. 5D gezeigten Ausführungsbeispiel dargestellt ist, dreieckig ausgebildet werden, können auch dreieckige Reaktionskanäle 12 geschaffen werden.

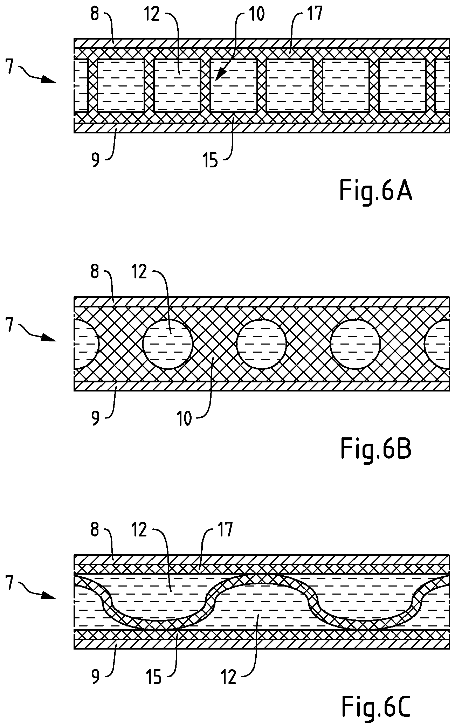

In den Fig. 6A-C sind beispielhaft verschiedene Schichtverbunde 7 umfassend die beiden Elektroden 8,9 und ein dazwischen angeordnetes Dielektrikum 10 dargestellt, wobei die nebeneinander angeordneten Reaktionskanäle 12 vollständig im Dielektrikum 10 aufgenommen sind und mithin nicht an eine der beiden Elektroden 8,9 angrenzen. Im Ausführungsbeispiel gemäß Fig. 6A weist das Dielektrikum 10 zwei flächig an jeweils einer der beiden Elektroden anliegende Schichten 15,17 auf. Zwischen diesen Schichten 15,17 erstrecken sich Stege 16 mit einem rechteckigen Querschnitt, so dass sich im Dielektrikum 10 selbst auch rechteckige Reaktionskanäle 12 ausbilden. Bei dem Ausführungsbeispiel gemäß Fig. 6B sind in dem Dielektrikum 10 Reaktionskanäle 12 mit einem wenigstens im Wesentlichen kreisrunden freien Strömungsquerschnitt vorgesehen. Das Dielektrikum 10 der Fig. 6C weist dagegen ein wellenförmiges oder sinusförmiges Profil auf, das sich zwischen zwei flächig an jeweils einer der beiden Elektroden 8,9 anliegenden Schichten 15,17 des Dielektrikums 10 erstreckt.

### Bezugszeichenliste

- 1: Plasmareaktor
- 2: Leitung
- 3: Reaktorfluid
- 4: Leitung
- 5: Spannungsquelle
- 6: Spulenkern
- 7: Schichtverbund
- 8,9: Elektrode
- 10: Dielektrikum
- 11: Strömungskanal
- 12: Reaktionskanal
- 13: Temperierkanal
- 14: Gehäuse
- 15: Schicht
- 16: Steg
- 17: Schicht

## Patentansprüche

1. Plasmareaktor (1) zur plasmachemischen und/oder plasmakatalytischen Umsetzung von Verbindungen in einem Reaktorfluid mittels dielektrischer Barriereentladung, umfassend zwei wenigstens über ein Dielektrikum (10) und wenigstens abschnittsweise über wenigstens einen Reaktionskanal (12) zum Durchströmen des Reaktorfluids (3) voneinander getrennte Elektroden (8,9), wobei die Elektroden (8,9) und das Dielektrikum (10) spiralförmig um die Reaktorlängserstreckung gewickelt sind, **dadurch gekennzeichnet, dass** der Reaktionskanal (12) zum Durchströmen mit dem Reaktorfluid (3) wenigstens im Wesentlichen parallel zu einer Reaktorlängserstreckung ausgebildet ist.

2. Plasmareaktor nach Anspruch 1, wobei die Elektroden (8,9) und das Dielektrikum (10) wenigstens zweimal, vorzugsweise wenigstens dreimal, insbesondere wenigstens fünfmal, spiralförmig um die Reaktorlängserstreckung gewickelt sind und/oder dass die Elektroden (8,9) und das Dielektrikum (10) um einen Spulenkern (6) herum gewickelt sind.

3. Plasmareaktor nach Anspruch 1 oder 2, wobei der wenigstens eine Reaktionskanal (12) durch eine der beiden Elektroden (8,9) und/oder das Dielektrikum (10) begrenzt wird.

4. Plasmareaktor nach Anspruch 3, wobei wenigstens ein Reaktionskanal (12) durch eine der beiden Elektroden (8,9) und wenigstens ein anderer Reaktionskanal (12) durch die andere Elektrode (9,8) begrenzt wird.

5. Plasmareaktor nach einem der Ansprüche 1 bis 4, wobei eine Mehrzahl, vorzugsweise eine Vielzahl, insbesondere wenigstens 20, weiter insbesondere wenigstens 50, separater Reaktionskanäle (12) wenigstens im Wesentlichen parallel zueinander und/oder wenigstens im Wesentlichen parallel zur Reaktorlängserstreckung vorgesehen sind.

6. Plasmareaktor nach einem der Ansprüche 1 bis 5, wobei der wenigstens eine Reaktionskanal (12) eine freie Querschnittsfläche von wenigstens 0,5 mm², vorzugsweise wenigstens 1 mm², insbesondere wenigstens 5 mm² aufweist und/oder dass der wenigstens eine Reaktionskanal eine freie Querschnittsfläche von weniger als 200 mm², vorzugsweise von weniger als 100 mm², insbesondere von weniger als 50 mm² aufweist.

7. Plasmareaktor nach einem der Ansprüche 1 bis 6, wobei der freie Querschnitt des wenigstens einen Reaktionskanals (12) rund, oval, halbkreisförmig, dreieckig, rechteckig oder quadratisch ist.

8. Plasmareaktor nach einem der Ansprüche 1 bis 7, wobei das Dielektrikum (10) aus einem Kunststoff, vorzugsweise aus Polydimethylsiloxan (PDMS), Silikon und/oder Kautschuk, gebildet ist und/oder dass die Elektroden (8,9) aus Edelstahl, Kupfer, Kupferlegierungen, Nickel, Silber, Platin und/oder Palladium gebildet sind.

9. Plasmareaktor nach einem der Ansprüche 1 bis 8, wobei der wenigstens eine Reaktionskanal (12) wenigstens abschnittsweise eine Katalysatorbeschichtung aufweist und dass, vorzugsweise, das Dielektrikum (10) und/oder eine Elektrode (8,9) katalysatorbeschichtet ist oder der Katalysator dispers im Reaktionskanal (12) angeordnet oder Teil des Reaktorfluids (3) ist.

10. Plasmareaktor nach einem der Ansprüche 1 bis 9, wobei zwischen den Elektroden (8,9) wenigstens ein Temperierkanal (13) zum Hindurchleiten eines Wärmeträgerfluids zum Beheizen oder Kühlen des wenigstens einen Reaktionskanals (12) vorgesehen ist.

11. Verwendung eines Plasmareaktors (1) nach einem der Ansprüche 1 bis 10, zur Reduzierung von Restsauerstoff aus Synthesegas oder Hüttengas, zum Entfernen von Stickoxiden, Schwefeloxiden, Lachgas, flüchtigen organischen Verbindungen (VOC), Methan, Propan, Ammoniak, Geruchsstoffen und/oder Partikeln aus Synthesegas, Prozessgas oder Abgas und/oder zur Entfernung von Odorierungsmittel aus Erdgas, zur Entfernung von Ruß, Gerüchen aus Gasen und/oder zur Abtötung von Mikroorganismen wie Keimen, Bakterien, Sporen, Pilzen in Fluiden.

12. Verwendung eines Plasmareaktors (1) nach einem der Ansprüche 1 bis 10, zur Erzeugung eines atmosphärischen Plasmas und/oder eines Niedertemperaturplasmas und/oder eines unter Überdruck stehenden Plasmas.

## Claims

1. Plasma reactor (1) for plasma-chemical and/or plasma-catalytic conversion of compounds in a reactor fluid by means of dielectric barrier discharge, comprising two electrodes (8,9) separated from one another by means of a dielectric (10) and at least in sections along at least one reactor channel (12) for through flow of the reactor fluid (3), wherein the electrodes (8, 9) and the dielectric (10) are wound spirally around the reactor longitudinal extension, **characterized in that** the reaction channel (12) is designed for through flow of the reactor fluid (3) at least substantially parallel to a reactor longitudinal extension.

2. Plasma reactor according to claim 1, wherein the electrodes (8, 9) and the dielectric (10) are wound spirally at least twice, preferably at least three times, in particular at least five times, around the longitudinal extension of the reactor and/or that the electrodes (8, 9) and the dielectric (10) are wound around a coil core (6).

3. Plasma reactor according to claim 1 or 2, wherein the at least one reaction channel (12) is bounded by one of the two electrodes (8, 9) and/or the dielectric (10).

4. Plasma reactor according to claim 3, wherein at least one reaction channel (12) is bounded by one of the two electrodes (8, 9) and at least one other reaction channel (12) is bounded by the other electrode (9, 8).

5. Plasma reactor according to one of claims 1 to 4, wherein a plurality, preferably a multitude, in particular at least 20, further in particular at least 50, of separate reaction channels (12) are provided at least substantially parallel to each other and/or at least substantially parallel to the reactor longitudinal extension.

6. Plasma reactor according to one of claims 1 to 5, wherein the at least one reaction channel (12) has a free cross-sectional area of at least 0.5 mm², preferably at least 1 mm², in particular at least 5 mm² and/or that the at least one reaction channel has a free cross-sectional area of less than 200 mm², preferably of less than 100 mm², in particular of less than 50 mm².

7. The plasma reactor according to one of claims 1 to 6, wherein the free cross-section of the at least one reaction channel (12) is round, oval, semicircular, triangular, rectangular or square.

8. Plasma reactor according to one of claims 1 to 7, wherein the dielectric (10) is formed from a plastic material, preferably from polydimethylsiloxane (PDMS), silicone and/or rubber, and/or that the electrodes (8, 9) are formed from stainless steel, copper, copper alloys, nickel, silver, platinum and/or palladium.

9. Plasma reactor according to one of claims 1 to 8, wherein the at least one reaction channel (12) has a catalyst coating at least in sections and that, preferably, the dielectric (10) and/or an electrode (8, 9) has a catalyst coating or the catalyst is arranged in a dispersed manner in the reaction channel (12) or is part of the reactor fluid (3).

10. Plasma reactor according to one of claims 1 to 9, wherein at least one temperature control channel (13) is provided between the electrodes (8, 9) for passing a heat transfer fluid for heating or cooling the at least one reaction channel (12).

11. Use of a plasma reactor (1) according to one of claims 1 to 10, for reducing of residual oxygen from synthesis gas or metallurgical gas, for the removal of nitrogen oxides, sulfur oxides, nitrous oxide, volatile organic compounds (VOC), methane, propane, ammonia, odorous substances and/or particles from synthesis gas, process gas or waste gas and/or to remove odorants from natural gas, to remove soot, odors from gases and/or to kill microorganisms such as germs, bacteria, spores, fungi in fluids.

12. Use of a plasma reactor (1) according to one of claims 1 to 10, for generating an atmospheric plasma and/or a low-temperature plasma and/or a pressurized plasma.

## Revendications

1. Réacteur à plasma (1) pour conversion plasmochimique et/ou plasmocatalytique de composés dans un fluide de réacteur au moyen d'une décharge à barrière diélectrique, comprenant deux électrodes (8, 9, 10) séparées l'une de l'autre au moins par un diélectrique (10) et au moins par sections par au moins un canal de réaction (12) pour le passage du fluide de réacteur (3), où les électrodes (8, 9) et le diélectrique (10) sont enroulés en spirale autour de l'extension longitudinale de réacteur, **caractérisé en ce que** le canal de réaction (12) formé à être traversé par le fluide du réacteur (3) au moins essentiellement parallèlement à une extension longitudinale de réacteur.

2. Réacteur à plasma selon la revendication 1, où les électrodes (8, 9) et le diélectrique (10) sont enroulés en spirale au moins deux fois, de préférence au moins trois fois, en particulier au moins cinq fois, autour de l'extension longitudinale de réacteur et/ou que les électrodes (8, 9) et le diélectrique (10) sont enroulés autour d'un noyau de bobine (6).

3. Réacteur à plasma selon la revendication 1 ou 2, où le au moins un canal de réaction (12) est délimité par l'une des deux électrodes (8, 9) et/ou le diélectrique (10).

4. Réacteur à plasma selon la revendication 3, où au moins un canal de réaction (12) est délimité par l'une des deux électrodes (8, 9) et au moins un autre canal de réaction (12) est délimité par l'autre électrode (9, 8).

5. Réacteur à plasma selon l'une des revendications 1 à 4, où une pluralité, de préférence une multitude, en particulier au moins 20, en particulier encore au moins 50, de canaux de réaction (12) séparés sont prévus au moins essentiellement parallèlement les uns aux autres et/ou au moins essentiellement parallèlement à l'extension longitudinale de réacteur.

6. Réacteur à plasma selon l'une des revendications 1 à 5, où le au moins un canal de réaction (12) a une surface de section transversale libre d'au moins 0,5 mm², de préférence d'au moins 1 mm², en particulier d'au moins 5 mm² et/ou que le au moins un canal de réaction a une surface de section transversale libre de moins de 200 mm², de préférence de moins de 100 mm², en particulier de moins de 50 mm² .

7. Réacteur à plasma selon l'une des revendications 1 à 6, où la section transversale libre d l'au moins un canal de réaction (12) est ronde, ovale, semi-circulaire, triangulaire, rectangulaire ou carrée.

8. Réacteur à plasma selon l'une des revendications 1 à 7, où le diélectrique (10) est formé d'une matière plastique, de préférence de polydiméthylsiloxane (PDMS), de silicone et/ou de caoutchouc, et/ou que les électrodes (8, 9) sont formées d'acier inoxydable, de cuivre, d'alliages de cuivre, de nickel, d'argent, de platine et/ou de palladium.

9. Réacteur à plasma selon l'une des revendications 1 à 8, où le au moins un canal de réaction (12) a au moins par sections un revêtement de catalyseur et que, de préférence, le diélectrique (10) et/ou une électrode (8, 9) est revêtu(e) de catalyseur ou le catalyseur est disposé de manière dispersée dans le canal de réaction (12) ou fait partie du fluide du réacteur (3).

10. Réacteur à plasma selon l'une des revendications 1 à 9, où au moins un canal de régulation de température (13) est prévu entre les électrodes (8, 9) pour le passage d'un fluide caloporteur pour chauffer ou refroidir au moins un canal de réaction (12).

11. Utilisation d'un réacteur à plasma (1) selon l'une des revendications 1 à 10, pour réduire l'oxygène résiduel du gaz de synthèse ou du gaz métallurgique, pour éliminer des oxydes d'azote, des oxydes de soufre, du gaz hilarant, des composés organiques volatils (COV), du méthane, du propane, de l'ammoniac, des substances odorantes et/ou des particules du gaz de synthèse, du gaz de processus ou du gaz d'échappement et/ou pour éliminer les odorants de gaz naturel, pour éliminer de la suie, des odeurs de gaz et/ou pour tuer des micro-organismes comme des germes, des bactéries, des spores, des champignons dans des fluides.

12. Utilisation d'un réacteur à plasma (1) selon l'une des revendications 1 à 10, pour produire un plasma atmosphérique et/ou un plasma à basse température et/ou un plasma en surpression.
